# EUROPÄISCHE PATENTANMELDUNG

(11) **EP 2 161 838 A2**
(43) Veröffentlichungstag der Anmeldung: **10.03.2010**
(21) Anmeldenummer: 09167823.5
(22) Anmeldetag: 13.08.2009
(51) Int. Cl.: H03K 17/96, F25D 29/00, H03K 17/955

(54) **Elektrisches Haushaltsgerät sowie Glasfrontplatte für elektrisches Haushaltsgerät**

(30) Priorität: 14.08.2008 CN 200810021816
(71) Anmelder: BSH Bosch und Siemens Hausgeräte GmbH, 81739 München (DE)
(72) Erfinder: Han, Yean, 239000 Chuzhou (CN); Lin, Zhigang, 239000 Chuzhou (CN); Rupp, Alexander, 239016 Chuzhou (CN); Wang, Yonghong, 239000 Chuzhou (CN)

(57) **Zusammenfassung**

Die vorliegende Erfindung betrifft ein elektrisches Haushaltsgerät, insbesondere einen Kühlschrank (1), wobei das vorstehend bezeichnete elektrische Haushaltsgerät aufweist: mehrere Schaltervorrichtungen (2), wobei jede der Schaltervorrichtungen (2) Bedienzonen (8) zur Belastung durch Finger des Benutzers aufweist und wobei an jeder der Bedienzonen (8) Anzeigesymbole (3) gebildet werden; sowie
Beleuchtungselemente (6) zur Beleuchtung der vorstehend bezeichneten Bedienzonen (8) von der Innenseite her.
Entsprechend dem Planungsentwurf der vorliegenden Erfindung sind die vorstehend bezeichneten Anzeigesymbole (3) halbtransparent und die restlichen Regionen (5) der Bedienzonen (8) sind nicht transparent.

## Beschreibung

### [Technisches Gebiet]

Die vorliegende Erfindung betrifft ein elektrisches Haushaltsgerät, insbesondere einen Kühlschrank, wobei das vorstehend bezeichnete elektrische Haushaltsgerät aufweist: mehrere Schaltervorrichtungen, wobei jede der Schaltervorrichtungen Bedienzonen zur Belastung durch Finger des Benutzers aufweist und wobei an jeder der Bedienzonen Anzeigesymbole gebildet werden. Das vorstehend bezeichnete elektrische Haushaltsgerät weist außerdem Beleuchtungselemente zur Beleuchtung der vorstehend bezeichneten Bedienzonen von der Innenseite her auf. Die vorliegende Erfindung betrifft außerdem die Glasfrontplatte eines elektrischen Haushaltsgerätes.

### [Stand der Technik]

In US 6,664,489 B2 wird ein Sensorschalter in Tastkontaktausführung offenbart, welcher an einem wie vorstehend aufgeführten elektrischen Haushaltsgerät verwendet werden kann. An jedem Schalter wird eine entsprechende Leuchtdiode vorgesehen. Wenn der Schalter in Tastkontaktausführung infolge von Tastkontakt eine Abänderung der elektrischen Kapazität erfährt und somit aktiviert wird, wird die vorstehend bezeichnete Leuchtdiode angeschaltet. Auf diese Weise wird die Bedienzone des betreffenden Schalters beleuchtet, um den Erfolg der Tastkontaktbedienung anzuzeigen. Jeder Schalter weist dicht an der Innenseite der Frontplatte befindliche Sensorelemente auf, wobei die Sensorelemente transparente Rillen aufweisen, so dass das durch die Rillen strahlende Licht auf die Frontplatte projiziert wird und dort die entsprechenden Symbole darstellt.

Während diese Symbole lediglich der Darstellung der erfolgreichen Bedienung durch den Benutzer dienen, können die den an verschiedenen Positionen befindlichen Schaltern entsprechenden Symbole identisch sein. Es ist allerdings bei einigen Anwendungssituationen erforderlich, dass Anzeigesymbole vorgesehen werden, welche die entsprechende Bedeutung jedes Schalters erklären/anzeigen beziehungsweise die Bedeutung der erfolgreiche Bedienung des entsprechenden Schalters ausdrücken. Aus diesem Grund müssen diese Symbole, wenn sie zur Anzeige von Schalterbedienungsinhalten verwendet werden, verschieden sein.

Es ist zwar möglich, durch eine vernünftige Anordnung der Rillenform der Sensorelemente Anzeigesymbole mit verschiedenen Inhalten zu bilden. Diese Sensorelemente mit verschiedenen Rillenformen führen aber unvermeidbar dazu, dass die Beschäftigten bei der Montage der Sensorelemente eine hohe Aufmerksamkeit aufbringen müssen, um die mit verschiedenen Kennzeichnungen versehenen Sensorelemente zu unterscheiden. Daher werden bei der Montage leicht Fehler begangen, so dass die Effizienz der Montage nicht hoch ist. Außerdem besteht in Hinblick auf elektrische Geräte verschiedener Typen stets eine Differenzierung der Kennzeichnungen mittels besonderem Design. Entsprechend dem gegenwärtigen Stand der Technik führt dies zu einer enormen Abnahme der Allgemeinverwendbarkeit/Austauschbarkeit der Einzelkomponenten von elektrischen Geräten verschiedener Typen.

In CN2829216Y wird eine Tastkontaktschaltervorrichtung in Sensorausführung für elektrische Haushaltsgeräte offenbart. Die betreffende Schaltervorrichtung weist eine mit zumindest einer Bedienzone versehene Glasfrontplatte, den Bedienzonen entsprechende und an der Innenseite der Frontplatte vorgesehene Sensorelemente sowie den Bedienzonen entsprechende Anzeigelichtquellen auf. Zwischen Bedienzonen und Anzeigelichtquellen werden Lichtstreuungsplatten vorgesehen. Auf diese Weise kann die allgemeine Anwendbarkeit der Sensorelemente enorm erweitert werden. Außerdem wird durch die Lichtstreuungswirkung der lichtstreuenden Platte, welche die gesamte Bedienzone abdeckt, bewirkt, dass das die Bedienzone durchstrahlende Licht gleichmäßig und mild verteilt wird. Die Mangelhaftigkeit dieses Planungsentwurfes besteht allerdings darin, dass die lichtstreuende Platte zusätzlich bereitgestellt und montiert werden muss.

### [Inhalt der Erfindung]

Aus diesem Grund besteht die Zielsetzung der vorliegenden Erfindung in der Bereitstellung eines elektrischen Haushaltsgerätes, insbesondere eines Kühlschranks, bei welchem die vorstehend aufgeführten Mangelhaftigkeiten überwunden worden sind, sodass die Anzeigesymbole der Schalter auf milde Weise beleuchtet werden können, ohne dass es weiterer zusätzlicher überzähliger Einzelkomponenten bedarf, was sich positiv auf die Montage auswirkt.

Aus diesem Grund betrifft die vorliegende Erfindung ein elektrisches Haushaltsgerät, insbesondere einen Kühlschrank, wobei das vorstehend bezeichnete elektrische Haushaltsgerät aufweist: mehrere Schaltervorrichtungen, wobei jede der Schaltervorrichtungen Bedienzonen zur Belastung durch Finger des Benutzers aufweist und wobei an jeder der Bedienzonen Anzeigesymbole gebildet werden; sowie Beleuchtungselemente zur Beleuchtung der vorstehend bezeichneten Bedienzonen von der Innenseite her, dadurch gekennzeichnet, dass die vorstehend bezeichneten Anzeigesymbole halbtransparent sind und die restlichen Regionen der Bedienzonen nicht transparent sind.

Weil innerhalb der Bedienzonen die Anzeigesymbole transparent sind und die Stellen der Bedienzonen, welche nicht Anzeigesymbole sind, nicht transparent sind, wird bei Anschalten der Beleuchtungselemente bewirkt, dass bei nicht ausreichendem Licht das die Anzeigesymbole durchstrahlende Licht nach wie vor die Anzeigesymbole deutlich anzeigen kann. Weil die Anzeigesymbole außerdem für sich genommen halbtransparent sind, bedarf es keiner weiteren zusätzlichen lichtstreuenden Elemente, um zu erreichen, dass das Licht, welches die Anzeigesymbole durchstrahlt, sehr mild ist.

Weitere unabhängige oder mit anderen Besonderheiten der vorliegenden Erfindung in Zusammenhang stehende Merkmale werden in weiteren Patentansprüchen beschrieben. Bei einem besonders vorteilhaften praktischen Ausführungsbeispiel ist an den vorstehend bezeichneten Anzeigesymbolen eine halbtransparente erste dünne Schicht aufgedruckt. Auf diese Weise erfolgt eine enorme Erweiterung des Auswahlbereiches für Material, Farbe und Konstruktion der Frontplatte.

Besonders vorteilhaft ist es, wenn die vorstehend bezeichnete erste dünne Schicht die innere Oberfläche beziehungsweise die äußere Oberfläche der vorstehend bezeichneten Bedienzonen vollständig abdeckt, sodass die erste dünne Schicht auch bei sehr komplizierten und winzigen Anzeigesymbolen dennoch leicht auf die vorstehend bezeichneten Anzeigesymbole gedruckt werden kann und das Licht bei Strahlen auf die erste dünne Schicht Streuung erfährt und die Anzeigesymbole somit halbtransparent sind.

Bei einem besonders vorteilhaften praktischen Ausführungsbeispiel wird an den vorstehend bezeichneten restlichen Regionen eine nicht transparente zweite dünne Schicht aufgedruckt. Auf diese Weise erfolgt eine enorme Erweiterung des Auswahlbereiches für Material, Farbe und Konstruktion der Frontplatte. Es ist besonders vorteilhaft, wenn die vorstehend bezeichnete zweite dünne Schicht mittels Hohldruck die vorstehend bezeichneten Anzeigesymbole bildet. Besonders vorteilhaft ist es, wenn innerhalb der vorstehend bezeichneten restlichen Regionen die vorstehend bezeichnete zweite dünne Schicht die vorstehend bezeichnete erste dünne Schicht abdeckt.

Vorteilhaft ist es, wenn die vorstehend bezeichnete erste dünne Schicht an der Innenseite der vorstehend bezeichneten Bedienzonen aufgedruckt wird, so dass die Anzeigesymbole nicht leicht Korrosion ausgesetzt sind, sich nicht ablösen oder am Rand undeutlich werden. Entsprechend einem vorteilhaften praktischen Ausführungsbeispiel der vorliegenden Erfindung weist das betreffende elektrische Haushaltsgerät eine Glasfrontplatte, welche die vorstehend bezeichneten mehreren Bedienzonen bildet, sowie mehrere jeweils den vorstehend bezeichneten Bedienzonen entsprechende kapazitative Sensorelemente auf. Besonders vorteilhaft ist es, wenn die vorstehend bezeichnete Glasfrontplatte mit der Tür des elektrischen Haushaltsgerätes verbunden wird.

Ein weiterer Aspekt der vorliegenden Erfindung betrifft eine Glasfrontplatte für ein elektrisches Haushaltsgerät, welche mehrere Bedienzonen zur Belastung durch Finger des Benutzers aufweist, und wobei an jeder der Bedienzonen Anzeigesymbole gebildet werden; dadurch gekennzeichnet, dass die vorstehend bezeichneten Anzeigesymbole halbtransparent sind und die restlichen Regionen der Bedienzonen nicht transparent sind. Vorteilhaft ist es, wenn an den vorstehend bezeichneten Anzeigesymbolen eine halbtransparente erste dünne Schicht aufgedruckt wird. Besonders vorteilhaft ist es, wenn die vorstehend bezeichnete erste dünne Schicht auf die gesamte Bedienzone aufgedruckt ist.

Es ist vorteilhaft, wenn die vorstehend bezeichneten restlichen Regionen mit einer nicht transparenten zweiten dünnen Schicht bedruckt werden, wobei die vorstehend bezeichnete zweite dünne Schicht durch Hohldruck die vorstehend bezeichneten Anzeigesymbole bildet. Es ist besonders vorteilhaft, wenn innerhalb der vorstehend bezeichneten restlichen Regionen die vorstehend bezeichnete zweite dünne Schicht die vorstehend bezeichnete erste dünne Schicht abdeckt.

Die Vorteile der Konstruktion der vorliegenden Erfindung sowie die sonstigen Zielsetzungen der Erfindung werden anhand der beigefügten Abbildungen sowie durch vorteilhafte praktische Ausführungsbeispiele näher erläutert.

### [Erläuterung der Abbildungen]

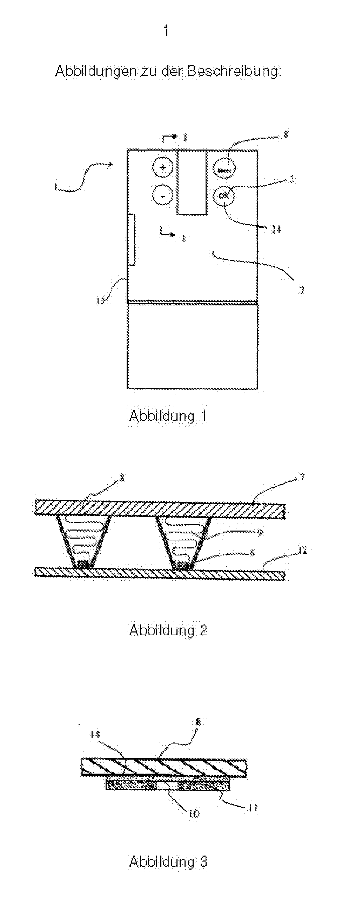

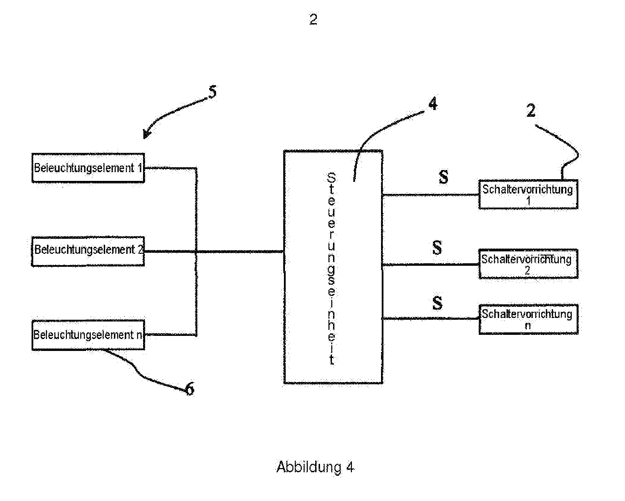

Als Teil der Beschreibung und zur besseren Erläuterung der vorliegenden Erfindung erfolgt durch die beigefügten Abbildungen und praktischen Ausführungsbeispiele in Verbindung mit der Beschreibung eine weitere Erklärung der vorliegenden Erfindung.
Bei der Abbildung 1 handelt es sich hierbei um die Frontansicht eines elektrischen Haushaltsgerätes 1 gemäß einem vorteilhaften praktischen Ausführungsbeispiel der vorliegenden Erfindung.
Bei der Abbildung 2 handelt es sich um eine regionale Schnittansicht entlang der Richtung I-I gemäß Abbildung 1.
Bei der Abbildung 3 handelt es sich um eine Schnittansicht der Frontplatte 7 gemäß einem vorteilhaften praktischen Ausführungsbeispiel der vorliegenden Erfindung.
Bei der Abbildung 4 handelt es sich um die Darstellung des Steuerungsstromkreises gemäß einem vorteilhaften praktischen Ausführungsbeispiel der vorliegenden Erfindung.

### [Praktische Ausführungsbeispiele]

Zunächst erfolgt besondere Berücksichtigung der Abbildung 1 aus den beigefügten Abbildungen.

Bei der Abbildung 1 handelt es sich um die Frontansicht eines elektrischen Haushaltsgerätes 1 gemäß einem vorteilhaften praktischen Ausführungsbeispiel der vorliegenden Erfindung. Das elektrische Haushaltsgerät 1 weist eine (nicht dargestellte) Aufbewahrungskammer zur Lagerung von Objekten wie Speisen, Lebensmitteln usw. sowie eine Tür 13 zum wahlweise Öffnen beziehungsweise Schließen der betreffenden Aufbewahrungskammer auf. Bei dem betreffenden praktischen Ausführungsbeispiel handelt es sich bei dem betreffenden elektrischen Haushaltsgerät 1 um einen Kühlschrank.

Mit der Vorderseite von Tür 13 ist die Frontplatte 7 verbunden. Die Frontplatte 7 bildet mehrere Bedienzonen 8 zur Belastung durch Finger des Benutzers. Bei dem vorliegenden praktischen Ausführungsbeispiel ist an der Frontplatte 7 ein ringförmiges Muster vorgesehen, um die Bedienzonen 8 anzuzeigen. Innerhalb von jeder Bedienzone 8 sind entsprechende Anzeigesymbole 3 vorgesehen, damit der Benutzer die entsprechende Bedienzone 8 für die Bedienung auswählen kann. Entsprechend der vorliegenden Erfindung können die Anzeigesymbole 3 Beschriftungen (beispielsweise chinesische Schriftzeichen oder lateinische Buchstaben), Grafiken, Ziffern sowie deren Kombinationen und weitere beliebige Symbole zum Ausdrücken der besonderen Bedeutung sein. Bei dem vorliegenden praktischen Ausführungsbeispiel ist die Frontplatte 7 aus Hartglas hergestellt. Die vordere Oberfläche der Bedienzonen 8 ist glatt.

Die Bedienzonen 8 stellen einen Teil der entsprechenden Schaltervorrichtungen 2 dar. Bei der Abbildung 2 handelt es sich um eine regionale Schnittansicht entlang der Richtung I-I gemäß Abbildung 1. Wie in Abbildung 2 gezeigt, handelt es sich bei den Schaltervorrichtungen 2 um kapazitative Sensorschalter, die außerdem ein hinter Bedienzone 8 befindliches Sensorelement 9 aufweisen. Bei dem vorliegenden praktischen Ausführungsbeispiel ist das Sensorelement 9 eine metallische Feder. Ein Ende des Sensorelementes 9 wird mit Frontplatte 7 verbunden, während das andere Ende mit Stromkreisplatte 12 verbunden, wird, welche einen gewissen Abstand zu Frontplatte 7 aufweist. Wenn der Finger des Benutzers Tastkontakt auf die Bedienzone 8 ausübt, erfolgt eine Abänderung der elektrischen Kapazität mit Aktivierung der Schaltervorrichtung 2. Das Prinzip des kapazitativen Sensorschalters 2 ist gegenwärtiger Stand der Technik und bedarf keiner weiteren Erläuterung.

An der Stromkreisplatte 12 wird Steuerungseinheit 4 vorgesehen. Die vorstehend bezeichneten anderen Enden der Sensorelemente 9 werden mit Steuerungseinheit 4 verbunden, so dass Schaltervorrichtung 2 und Steuerungseinheit 4 elektrisch verbunden sind. Wenn die Schaltervorrichtung 2 aktiviert wird, wird Signal S erzeugt und an die Steuerungseinheit 4 übertragen.

Zwischen Stromkreisplatte 12 und Frontplatte 7 wird Beleuchtungseinheit 5 vorgesehen. Bei dem vorliegenden praktischen Ausführungsbeispiel wird die Beleuchtungseinheit 5 in Gestalt von mehreren miteinander verbundenen Beleuchtungselementen 6 verwirklicht. An jeder Schaltervorrichtung 2 werden entsprechende Beleuchtungselemente 6 vorgesehen. Die Beleuchtungselemente 6 werden an der Stromkreisplatte 12 befestigt und weisen auf die entsprechende Bedienzone 8. Es ist vorteilhaft, wenn es sich bei den Beleuchtungselementen 6 um Leuchtdioden handelt.

Die Beleuchtungselemente 6 werden jeweils mit der Steuerungseinheit 4 elektrisch verbunden. Entsprechend der vorliegenden Erfindung wird die Steuerungseinheit 4 so vorgesehen, dass bei Erhalt von Signal S von einer beliebigen Schaltervorrichtung 2 durch Steuerungseinheit 4 jedes Beleuchtungselement 6 angeschaltet wird, so dass jedes Anzeigesymbol 3 beleuchtet wird. Dies kann über Software oder Hardware eingestellt werden.

Auf diese Weise werden bei Aktivierung von nur einer Schaltervorrichtung 2 sämtliche Anzeigesymbole 3 anzeigebeleuchtet. Aus diesem Grund kann der Benutzer auch bei nicht ausreichendem Umgebungslicht durch die Erläuterungen und/oder Anweisungen der Anzeigesymbole 3 die korrekte Bedienung vornehmen. Aus diesem Grund ist entsprechend der vorliegende Erfindung die Bedienung des elektrischen Haushaltsgerätes 1 erheblich bequemer.

Um nicht erforderlichen Energieverbrauch verhindern, werden bei dem vorliegenden praktischen Ausführungsbeispiel sämtliche Beleuchtungselemente 6 abgeschaltet, wenn die Steuerungseinheit 4 innerhalb von 10 Sekunden von keiner Schaltervorrichtung 2 ein anderes Signal S erhält.

Bei dem vorstehend aufgeführten praktischen Ausführungsbeispiel handelt es sich bei den Schaltervorrichtungen 2 um kapazitative Sensorschalter. Die vorliegende Erfindung ist aber nicht hierauf beschränkt. Die vorliegende Erfindung ist gleichermaßen für andersartige Schalter geeignet - beispielsweise für Druckschalter.

Bei der Abbildung 3 handelt es sich um eine Schnittansicht der Frontplatte 7 gemäß einem vorteilhaften praktischen Ausführungsbeispiel der vorliegenden Erfindung. Bei dem vorliegenden praktischen Ausführungsbeispiel wird zur Bildung der Anzeigesymbole 3 an der Innenseite von Frontplatte 7 durch Hohldruck eine nicht transparente zweite dünne Schicht 11 an den restlichen Regionen 14 der inneren Oberfläche der Tastkontaktzonen 8 aufgedruckt, welche nicht die Anzeigesymbole 3 sind. Auf diese Weise sind die restlichen Regionen 14 der Tastkontaktzonen 8, abgesehen von den Anzeigesymbolen 3, nicht transparent und bei Anschalten der Beleuchtungselemente 6 strahlt das Licht nur aus den Anzeigesymbolen 3, so dass der Benutzer die Anzeigesymbole 3 klar und deutlich erkennen kann.

Damit das die Frontplatte 7 durchstrahlende Licht sehr mild ist, wird an der Innenseite der Anzeigesymbole 3 eine halbtransparente erste dünne Schicht 10 aufgedruckt. Die erste dünne Schicht 10 bewirkt, dass das von den Beleuchtungselementen 6 ausgestrahlte Licht an den Anzeigesymbolen 3 Streuung bildet und sorgt somit dafür, dass die Anzeigesymbole 3 lichtdurchlässig aber nicht transparent sind (also halbtransparent). Weil die Anzeigesymbole 3 sehr kompliziert und winzig sein können, erfolgt bei dem vorliegenden praktischen Ausführungsbeispiel an der gesamten Innenseite der Bedienzone 8 Aufdrucken der ersten dünnen Schicht 10. Die erste dünne Schicht 10 wird am besten vor Hohldruckaufbringung der zweiten dünnen Schicht 11 an der Innenseite von Bedienzone 8 aufgedruckt.

Weil innerhalb der Bedienzonen 8 die Anzeigesymbole 3 transparent sind und die Stellen der Bedienzonen 8, welche nicht Anzeigesymbole sind, nicht transparent sind, wird bei Anschalten der Beleuchtungselemente 6 bewirkt, dass bei nicht ausreichendem Licht das die Anzeigesymbole 3 durchstrahlende Licht nach wie vor die Anzeigesymbole 3 deutlich anzeigen kann. Weil die Anzeigesymbole 3 außserdem für sich genommen halbtransparent sind, bedarf es keiner weiteren zusätzlichen lichtstreuenden Elemente, um zu erreichen, dass das Licht, welches die Anzeigesymbole 3 durchstrahlt, sehr mild ist.

### Erläuterung der Bezugszeichen in den beigefügten Abbildungen:

1 Elektrisches Haushaltsgerät
2 Schaltervorrichtung
3 Anzeigesymbol
4 Steuerungseinheit
5 Beleuchtungseinheit
6 Beleuchtungselement
7 Frontplatte
8 Bedienzone
9 Sensorelement
10 Erste dünne Schicht
11 Zweite dünne Schicht
12 Stromkreisplatte
13 Tür
14 Restliche Regionen der Bedienzonen
S Signal

## Patentansprüche

1. Elektrisches Haushaltsgerät (1), insbesondere Kühlschrank, wobei das vorstehend bezeichnete elektrische Haushaltsgerät Folgendes aufweist:
mehrere Schaltervorrichtungen (2), wobei jede der Schaltervorrichtungen (2) Bedienzonen (8) zur Belastung durch Finger des Anwenders aufweist und wobei an jeder der Bedienzonen (8) Anzeigesymbole (3) gebildet werden; sowie
ein Beleuchtungselement (6) zur Beleuchtung der vorstehend bezeichneten Bedienzonen (8) von der Innenseite her,
**dadurch gekennzeichnet, dass** die vorstehend bezeichneten Anzeigesymbole (3) halbtransparent sind und die restlichen Regionen (14) der Bedienzonen (8) nicht transparent sind.

2. Elektrisches Haushaltsgerät (1) gemäß Patentanspruch 1, **dadurch gekennzeichnet, dass** an den vorstehend bezeichneten Anzeigesymbolen (3) eine halbtransparente erste dünne Schicht (10) aufgedruckt ist.

3. Elektrisches Haushaltsgerät (1) gemäß Patentanspruch 2, **dadurch gekennzeichnet, dass** die vorstehend bezeichnete erste dünne Schicht (10) die innere Oberfläche beziehungsweise die äußere Oberfläche der vorstehend bezeichneten Tastkontaktzonen (8) vollständig abdeckt.

4. Elektrisches Haushaltsgerät (1) gemäß Patentanspruch 1, 2 oder 3, **dadurch gekennzeichnet, dass** an den restlichen Regionen (14) eine nichttransparente zweite dünne Schicht (11) aufgedruckt wird.

5. Elektrisches Haushaltsgerät (1) gemäß Patentanspruch 4, **dadurch gekennzeichnet, dass** die vorstehend bezeichnete zweite dünne Schicht (11) mittels Hohldruck die vorstehend bezeichneten Anzeigesymbole (3) bildet.

6. Elektrisches Haushaltsgerät (1) gemäß Patentanspruch 4 oder 5, **dadurch gekennzeichnet, dass** innerhalb der vorstehend bezeichneten restlichen Regionen (14) die vorstehend bezeichnete zweite dünne Schicht (11) die vorstehend bezeichnete erste dünne Schicht (10) abdeckt.

7. Elektrisches Haushaltsgerät (1) gemäß einem beliebigen der Patentansprüche 2-6,
**dadurch gekennzeichnet, dass** die vorstehend bezeichnete erste dünne Schicht (10) an der Innenseite der vorstehend bezeichneten Bedienzonen (8) aufgedruckt wird.

8. Elektrisches Haushaltsgerät (1) gemäß einem beliebigen der vorstehend aufgeführten Patentansprüche, **dadurch gekennzeichnet, dass** dieses die Glasfrontplatte (7), welche die vorstehend bezeichneten mehreren Bedienzonen (8) bildet, sowie mehrere jeweils den vorstehend bezeichneten Bedienzonen (8) entsprechende kapazitative Sensorelemente (9) aufweist.

9. Elektrisches Haushaltsgerät (1) gemäß Patentanspruch 8, **dadurch gekennzeichnet, dass** die vorstehend bezeichnete Glasfrontplatte (7) mit der Tür (13) des elektrischen Haushaltsgerätes (1) verbunden wird.

10. Glasfrontplatte (7) für elektrisches Haushaltsgerät, welche mehrere Bedienzonen (8) zur Belastung durch Finger des Anwenders aufweist, wobei an jeder der Bedienzonen (8) Anzeigesymbole (3) gebildet werden, **dadurch gekennzeichnet, dass** die vorstehend bezeichneten Anzeigesymbole (3) halbtransparent sind und die restlichen Regionen (14) der Bedienzonen (8) nicht transparent sind.

11. Glasfrontplatte (7) gemäß Patentanspruch 10, **dadurch gekennzeichnet, dass** an den vorstehend bezeichneten Anzeigesymbolen (3) eine halbtransparente erste dünne Schicht (10) aufgedruckt wird.

12. Glasfrontplatte (7) gemäß Patentanspruch 11, **dadurch gekennzeichnet, dass** die vorstehend bezeichnete erste dünne Schicht (10) die innere Oberfläche der vorstehend bezeichneten Tastkontaktzonen (8) vollständig abdeckt.

13. Glasfrontplatte (7) gemäß Patentanspruch 10, 11 oder 12, **dadurch gekennzeichnet, dass** die vorstehend bezeichneten restlichen Regionen (14) mit einer nicht transparenten zweiten dünnen Schicht (11) bedruckt werden, wobei die vorstehend bezeichnete zweite dünne Schicht (11) durch Hohldruck die vorstehend bezeichneten Anzeigesymbole (3) bildet.

14. Glasfrontplatte (7) gemäß Patentanspruch 13, **dadurch gekennzeichnet, dass** innerhalb der vorstehend bezeichneten restlichen Regionen (14) die vorstehend bezeichnete zweite dünne Schicht (11) die vorstehend bezeichnete erste dünne Schicht (10) abdeckt.
